# DEMANDE DE BREVET EUROPEEN

(11) **EP 4 711 885 A1**
(43) Date de publication de la demande: **18.03.2026**
(21) Numéro de dépôt: 25200762.0
(22) Date de dépôt: 08.09.2025
(51) Int. Cl.: G05G 25/04, G08C 17/04, G08C 17/02, H03K 17/97, G05G 1/08, G08C 13/00, H03K 17/94, H04Q 9/00

(54) **TÉLÉCOMMANDE POUR INSTALLATION DE PROTECTION SOLAIRE À MOLETTE DE COMMANDE AIMANTÉE**

(30) Priorité: 09.09.2024 FR 2409562
(71) Demandeur: Somfy Activites SA, 74300 Cluses (FR)
(72) Inventeur: ROBERT, Héléna, 74300 CLUSES (FR)
(74) Mandataire: Germain Maureau

(57) **Abrégé**

Une télécommande (T) configurée pour commander une unité de contrôle (U) d'une installation de protection solaire (I) comprend un boitier (10), un circuit électronique de commande (100) et une interface homme-machine (300) accessible depuis l'extérieur du boitier (10). L'interface homme-machine (300) comprend une molette de commande (400) avec au moins un élément magnétiquement actif (402) et le circuit électronique de commande (100) comprend un capteur magnétique (108) en situation de couplage magnétique avec l'élément magnétiquement actif (402). Cela permet d'évaluer le positionnement de l'élément magnétiquement actif (402) par rapport au boitier (10) et d'en déduire un paramètre de commande associé au mouvement de rotation de la molette de commande (400). Le boitier (10) délimite une paroi d'obturation étanche (18) interposée entre le circuit électronique de commande (100) et la molette de commande (400) et assurant une continuité de matière avec le reste de la matière du boitier (10) de sorte à conférer une étanchéité aux fluides extérieurs au boitier (10).

## Description

### Domaine technique de l'invention

La présente invention concerne une télécommande configurée pour commander une unité de contrôle d'une installation de protection solaire, la télécommande comprenant :
- un boitier,
- un circuit électronique de commande logé dans le boitier, le circuit électronique de commande comprenant un émetteur d'ondes électromagnétiques adaptées à la commande à distance de l'unité de contrôle,
- une interface homme-machine accessible depuis l'extérieur du boitier, l'interface homme-machine comprenant une molette de commande apte à être manipulée par la main de l'utilisateur de la télécommande et montée sur le boitier d'une manière offrant au moins une aptitude de mouvement de rotation de la molette de commande par rapport au boitier autour d'un axe principal.

### Etat de la technique

Il existe déjà des télécommandes nomades et portatives configurées pour commander une unité de contrôle d'une installation de protection solaire.

De telles installations de protection solaire peuvent être de type brise-soleil à lames orientables, stores vénitiens, des pergolas à lames orientables, ou toute forme d'installation ayant au moins un écran solaire apte à être déployé sur une course donnée et/ou orientable sur une plage angulaire donnée. Pour le déplacement des pièces destinées à l'obturation solaire, l'installation de protection solaire comprend classiquement au moins un actionneur destiné à être commandé par l'unité de contrôle.

Il est connu que la télécommande, qui est destinée à commander le ou les actionneurs prévus, comprenne à cet effet un boitier, un circuit électronique de commande logé dans le boitier et une interface homme-machine accessible depuis l'extérieur du boitier. Le circuit électronique de commande comprend classiquement un émetteur d'ondes électromagnétiques adaptées à la commande à distance de l'unité de contrôle. Plus précisément, les ondes électromagnétiques émises sont représentatives d'un ordre de commande à destination de l'unité de contrôle, laquelle convertit cet ordre de commande et transmet elle-même un ordre de commande circonstancié à l'actionneur concerné.

Dans ces applications où il est nécessaire d'ajuster une variable d'état associée à une plage de déplacement ou à une plage d'orientation angulaire de la pièce d'obturation solaire, il est connu que l'interface homme-machine comprenne une molette de commande, voire également un bouton d'appui indépendant de la molette de commande, tous deux aptes à être manipulés par la main de l'utilisateur de la télécommande depuis l'extérieur du boitier.

Pour le fonctionnement de la télécommande, il est nécessaire que le circuit électronique de commande de la télécommande puisse connaitre à chaque instant la position angulaire de la molette de commande, pour en déduire un paramètre de commande associé au mouvement de rotation de la molette de commande, ce paramètre de commande pouvant être soit une position angulaire discrète prise par la molette de commande parmi une pluralité de positions angulaires prédéterminées, soit une vitesse angulaire de rotation de la molette de commande. Ce paramètre de commande déduit par le circuit électronique de commande à partir du codeur rotatif est configuré pour être transmis à l'unité de contrôle par l'intermédiaire des ondes électromagnétiques susmentionnées et pour commander, par le biais de l'unité de contrôle, un paramètre de mouvement associé à l'actionneur correspondant de l'installation de protection solaire.

Le document EP1486640A1 décrit une solution dans laquelle la télécommande comprend un élément de commutation déplaçable par la mise en rotation en même temps de la télécommande. Un déplacement de la molette dans un premier sens de rotation implique un premier déplacement de l'élément de commutation afin que celui-ci mette en contact des premiers contacteurs électriques associés au circuit électronique en vue de la fermeture d'un premier circuit électrique. Un déplacement de la molette dans un deuxième sens de rotation implique un deuxième déplacement de l'élément de commutation afin que celui-ci mette en contact des deuxièmes contacteurs électriques associés au circuit électronique en vue de la fermeture d'un deuxième circuit électrique. Dans un mode de réalisation, la molette est équipée de dents qui actionnent dans un pivotement bidirectionnel, en fonction du sens de rotation de la molette, l'élément de commutation qui se présente alors sous la forme d'un levier pivotant autour d'un axe fixe. Le franchissement d'une dent étant représentative d'un pas angulaire prédéterminé, il devient possible de compter le nombre de pas parcourus durant la rotation de la molette. Il suffit pour cela de dénombrer le nombre de fermetures du premier circuit électrique, ou deuxième circuit électrique, respectivement.

Pour déterminer ce paramètre de commande, il est finalement connu d'équiper la télécommande d'un codeur rotatif incrémental, qui ajoute ou soustrait (selon le sens de rotation) une unité à un compteur à chaque rotation supérieure à une valeur seuil donnée.

Il est aussi connu d'utiliser le codeur rotatif pour générer, pour l'utilisateur de la télécommande, une sensation de crans au passage de chacune des positions angulaires prédéterminées de la molette de commande, afin de remplir une fonction dédiée ou pour une simple sensation de confort à l'utilisation.

De telles télécommandes sont destinées à une utilisation en intérieur ou en extérieur. Dans ce dernier cas, les télécommandes sont alors susceptibles d'être soumises à des conditions sévères de température et d'humidité, voire d'être exposées à des liquides comme la pluie, la neige, l'eau d'une piscine etc...

Les techniques connues décrites ci-avant impliquent la présence d'une liaison mécanique entre la molette de commande et le circuit électronique de commande et cela présente l'inconvénient qu'il est très difficile de parvenir à une étanchéité fiable et sûre dans le temps de la télécommande indépendamment des conditions de température et d'humidité environnantes.

### Objet de l'invention

La présente invention a pour but de proposer une télécommande pour installation de protection solaire du type précité, qui garantisse un très haut niveau d'étanchéité aux liquides, et ce de manière fiable dans le temps, en particulier dans la zone concernée par la présence de la molette de commande.

Ce but peut être atteint grâce à la fourniture d'une télécommande configurée pour commander une unité de contrôle d'une installation de protection solaire, la télécommande comprenant :
- un boitier,
- un circuit électronique de commande logé dans le boitier, le circuit électronique de commande comprenant un émetteur d'ondes électromagnétiques adaptées à la commande à distance de l'unité de contrôle,
- une interface homme-machine accessible depuis l'extérieur du boitier, l'interface homme-machine comprenant une molette de commande apte à être manipulée par la main de l'utilisateur de la télécommande et montée sur le boitier d'une manière offrant au moins une aptitude de mouvement de rotation de la molette de commande par rapport au boitier autour d'un axe principal,
télécommande dans laquelle :
- la molette de commande comprend au moins un élément magnétiquement actif et le circuit électronique de commande comprend un capteur magnétique, le capteur magnétique étant en situation de couplage magnétique avec l'élément magnétiquement actif d'une manière permettant au circuit électronique de commande d'évaluer le positionnement de l'élément magnétiquement actif par rapport au boitier et d'en déduire un paramètre de commande associé au mouvement de rotation de la molette de commande, ce paramètre de commande déduit par le circuit électronique de commande étant configuré pour commander, par le biais de l'unité de contrôle, un paramètre de mouvement associé à un actionneur de l'installation de protection solaire,
- le boitier délimite une paroi d'obturation étanche interposée entre le circuit électronique de commande et la molette de commande et assurant une continuité de matière avec le reste de la matière du boitier de sorte à conférer une étanchéité aux fluides extérieurs au boitier.

Le paramètre de commande est notamment une position angulaire discrète prise par la molette de commande parmi une pluralité de positions angulaires prédéterminées, mais il pourrait s'agir de la vitesse angulaire de rotation de la molette de commande.

Les dispositions précédentes permettent un découplage mécanique total entre d'une part la molette de commande équipée de son élément magnétiquement actif et d'autre part le circuit électronique de commande équipé de son capteur magnétique. Ce découplage mécanique autorise la présence très avantageuse de la paroi d'obturation étanche telle que mentionnée. Il en résulte la fourniture d'une télécommande garantissant un très haut niveau d'étanchéité aux liquides et aux fluides de manière générale, et ce de manière fiable dans le temps, en particulier dans la zone concernée par la présence de la molette de commande.

Certains aspects préférés mais non limitatifs de cette télécommande sont les suivants, pouvant être pris isolément ou en combinaison

Le boitier et la molette de commande comprennent respectivement des premiers éléments et des deuxièmes éléments d'un même mécanisme de retenue assurant un blocage de la molette de commande par rapport au boitier le long de l'axe principal.

Il en résulte que la seule liaison mécanique existante pour la molette de commande est la liaison mécanique ainsi obtenue entre la molette de commande et le boitier ; il n'existe aucune liaison mécanique entre la molette de commande et un autre composant de la télécommande, en particulier vis-à-vis du circuit électronique de commande. Cela contribue à conférer toutes les propriétés d'étanchéité déjà évoquées sans nuire aucunement au fonctionnement mécanique de la molette de commande par rapport au boitier ni au fonctionnement électrique de la molette de commande par l'entremise du couplage magnétique présent entre le capteur magnétique et l'élément magnétiquement actif.

Le boitier et la molette de commande comprennent respectivement des premiers organes mécaniques et des deuxièmes organes mécaniques d'un même mécanisme d'indexation angulaire et aptes à coopérer entre eux par appui et frottements de sorte à conférer, au sein de la course angulaire de rotation de la molette de commande autour de l'axe principal, une pluralité de positions angulaires stables prédéterminées que peut adopter sélectivement la molette de commande.

Ces dispositions permettent de conférer à l'utilisateur de la télécommande la sensation de crans durant le mouvement de rotation de la molette de commande. Cela permet un certain retour cognitif d'information et une évaluation manuelle directe de la rotation, tout en bloquant la molette de commande dans l'une des positions angulaires prédéterminées lors d'une absence d'action extérieure.

Le boitier présente une face supérieure et un évidement formé en creux dans la face supérieure du boitier, la paroi d'obturation matérialisant des cloisons dudit évidement et la molette de commande étant positionnée dans l'évidement de sorte qu'une surface de manipulation supérieure de la molette de commande affleure sensiblement avec la face supérieure du boitier.

Il en résulte que la télécommande est peu encombrante et ergonomique et pratique à manipuler, tout en limitant en outre le risque d'actionner involontairement la molette de commande durant la manipulation de la télécommande.

L'au moins un élément magnétiquement actif est constitué par un aimant permanent.

Ces dispositions permettent à la télécommande d'être à la fois économique et très robuste, l'élément magnétiquement actif étant alors insensible aux liquides.

L'interface homme-machine comprend un bouton d'appui, indépendant de la molette de commande, apte à être manipulé par la main de l'utilisateur de la télécommande depuis l'extérieur du boitier et monté sur le boitier d'une manière offrant au moins une aptitude de mouvement par rapport au boitier suivant au moins un degré de liberté par pivotement autour d'un axe de basculement orienté transversalement à l'axe principal, et/ou par translation le long de l'axe principal, pour varier, par application d'un effort manuel sur le bouton d'appui depuis l'extérieur du boitier, entre une position de repos et au moins une position d'actionnement.

Ces dispositions offrent la possibilité à la télécommande, grâce à la présence de ce bouton d'appui, de transmettre au circuit électronique de commande des informations d'activation différentes des informations d'activation qui peuvent déjà être transmises par la molette de commande. La télécommande peut ainsi remplir de plus nombreuses fonctions électriques, transmettre des ordres à l'unité de contrôle distincts entre la molette de commande et le bouton d'appui, commander de plus nombreux actionneurs de l'installation de protection solaire.

La molette de commande est conformée selon une forme générale tridimensionnelle de couronne et le bouton d'appui est aménagé au centre de cette couronne.

Cela permet une conception simple de l'interface homme-machine et limite son encombrement. Par ailleurs la rotation de la molette de commande n'est pas entravée par le bouton d'appui, et réciproquement la manipulation du bouton d'appui n'est pas entravée par la présence circonférentielle de la molette de commande.

Selon un premier mode de réalisation, le bouton d'appui comprend au moins un corps magnétiquement actif distinct de l'élément magnétiquement actif porté par la molette de commande, et le circuit électronique de commande comprend un capteur magnétique en situation de couplage magnétique avec le corps magnétiquement actif d'une manière permettant au circuit électronique de commande d'évaluer le positionnement du corps magnétiquement actif par rapport au boitier et d'en déduire un paramètre associé au mouvement du bouton d'appui.

Les dispositions précédentes permettent un découplage mécanique total entre d'une part le bouton d'appui équipé de son corps magnétiquement actif et d'autre part le circuit électronique de commande équipé du capteur magnétique associé. Ce découplage mécanique autorise la présence très avantageuse de la paroi d'obturation étanche telle que mentionnée. Il en résulte la fourniture d'une télécommande garantissant un très haut niveau d'étanchéité aux liquides et aux fluides de manière générale, et ce de manière fiable dans le temps, en particulier dans la zone concernée par la présence de la molette de commande.

L'au moins un corps magnétiquement actif est constitué par un aimant permanent.

Ces dispositions permettent à la télécommande d'être à la fois économique et très robuste, le corps magnétiquement actif étant alors insensible aux liquides.

Selon un second mode de réalisation alternatif, le circuit électronique de commande comprend au moins un interrupteur susceptible d'occuper un état actif et un état inactif et le bouton d'appui comprend un organe d'actionnement coopérant mécaniquement avec cet interrupteur à travers la paroi d'obturation et configuré de sorte que l'organe d'actionnement place l'interrupteur dans l'état actif lorsque le bouton d'appui est dans la position d'actionnement et place l'interrupteur dans l'état inactif lorsque le bouton d'appui est dans la position de repos.

La présence d'un tel interrupteur, sur lequel on appuie de manière mécanique indirectement au travers de la paroi d'obturation étanche, confère une très grande robustesse électrique à la télécommande et donc une excellente fiabilité.

La paroi d'obturation étanche comprend d'une part un rebord périphérique venant de matière avec la paroi d'obturation étanche et présentant un bord interne délimitant une ouverture à contour fermé et d'autre part un bloc central en matière élastomère déformable dont un pourtour périphérique est monté de manière étanche sur toute la longueur du bord interne du rebord périphérique.

Ces dispositions permettent de garantir le fonctionnement expliqué ci-avant entre le bouton d'appui et l'interrupteur de manière économique, simple et fiable, sans nuire aucunement à l'étanchéité aux fluides dans la zone de la télécommande concernée par la présence de la molette de commande.

L'interface homme-machine comprend un mécanisme de rappel sollicitant en permanence le bouton d'appui vers sa position de repos.

Ces dispositions permettent de définir, pour l'utilisation du bouton d'appui, une position d'actionnement qui est instable, c'est-à-dire adoptée uniquement si l'utilisateur exerce une force extérieure sur le bouton d'appui suffisante pour vaincre l'effort appliqué par le mécanisme de rappel, et une position de repos qui est stable, c'est-à-dire adoptée automatiquement dès que l'utilisateur n'exerce plus cette force extérieure sur le bouton d'appui. Ainsi, la position de repos est une position stable du bouton d'appui et l'au moins une position d'actionnement est une position instable du bouton d'appui.

Le mécanisme de rappel est constitué par le bloc central en matière élastomère déformable.

Ces dispositions permettent donc que le bloc central remplisse deux fonctions en même temps : à la fois la fonction d'étanchéité (malgré le couplage mécanique entre le bouton d'appui et l'interrupteur) et la fonction attendue du mécanisme de rappel. La télécommande est, une fois encore, plus simple, fiable et économique et limitée en encombrement général.

Le bloc central en matière élastomère déformable présente une forme de dôme faisant saillie en direction du circuit électronique de commande par rapport au rebord périphérique.

Ces dispositions permettent de limiter l'épaisseur de la télécommande en permettant que l'organe d'actionnement solidaire du bouton d'appui puisse traverser l'ouverture délimitée par le bord interne du rebord périphérique et ainsi atteindre de manière simple l'interrupteur.

Le boitier et le bouton d'appui comprennent respectivement des premiers éléments et des deuxièmes éléments d'un même mécanisme de blocage assurant un blocage bidirectionnel du bouton d'appui par rapport au boitier le long de l'axe principal et un blocage en rotation du bouton d'appui autour de l'axe principal.

Il en résulte que la seule liaison mécanique directe existante pour le bouton d'appui est la liaison mécanique ainsi obtenue entre le bouton d'appui et le boitier ; il n'existe aucune liaison mécanique directe entre le bouton d'appui et un autre composant de la télécommande, en particulier vis-à-vis du circuit électronique de commande. Cela contribue à conférer toutes les propriétés d'étanchéité déjà évoquées sans nuire aucunement au fonctionnement mécanique du bouton d'appui par rapport au boitier ni au fonctionnement électrique du bouton d'appui.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :

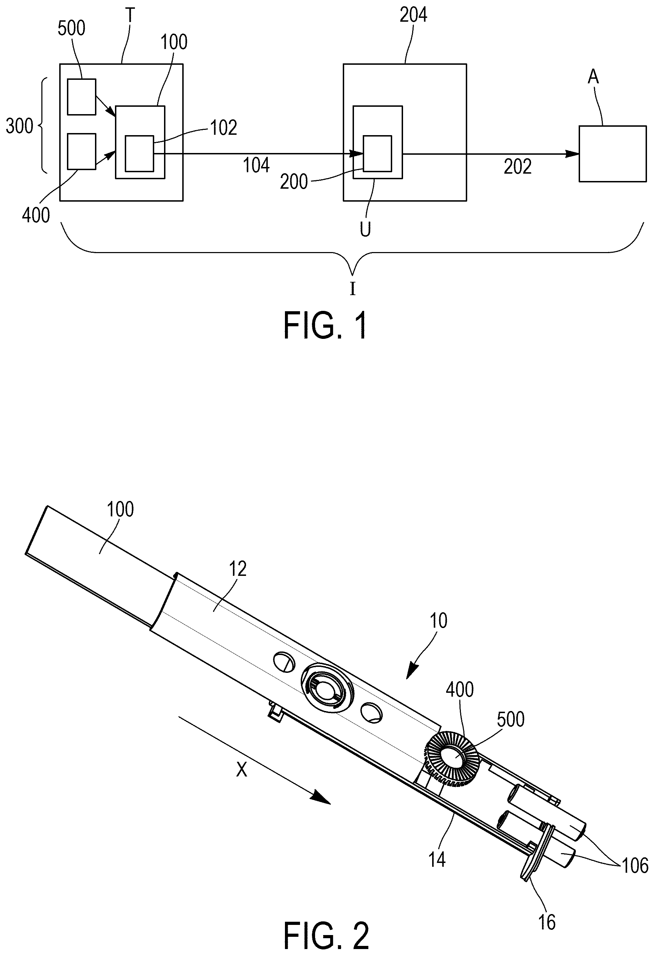

[Fig. 1] est une vue schématique illustrant différents composants d'un exemple d'installation de protection solaire.
[Fig. 2] est une vue éclatée partielle d'un exemple de télécommande selon l'invention.

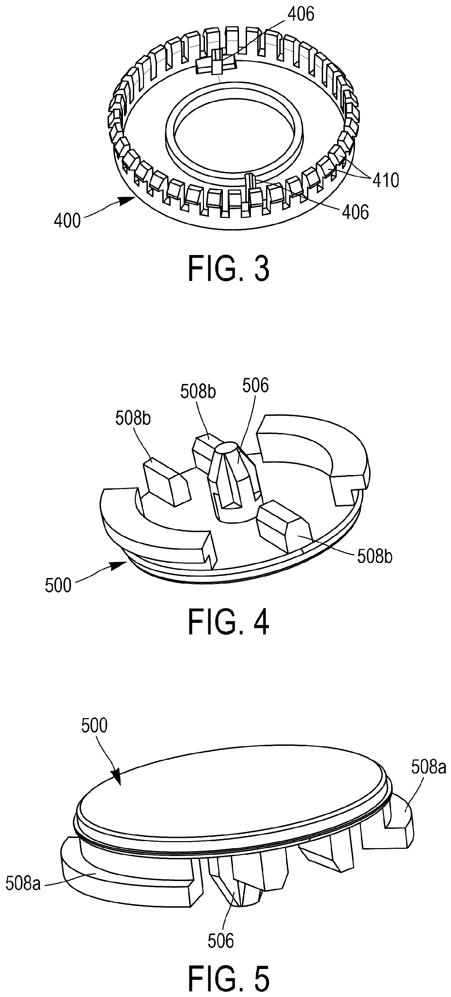

[Fig. 3] est une vue en perspective de dessous de la molette de commande.
[Fig. 4] est une vue en perspective de dessous du bouton d'appui.
[Fig. 5] est une vue en perspective de dessus du bouton d'appui.
[Fig. 6] est une vue en perspective de dessus du boitier.
[Fig. 7] est une vue en coupe longitudinale de la télécommande.
[Fig. 8] est une vue de détail de la figure 7 dans la zone concernée par la présence de la molette de commande.
[Fig. 9] est une vue schématique dans la zone concernée par la présence de la molette de commande selon un mode de réalisation.
[Fig. 10] est une vue schématique dans la zone concernée par la présence de la molette de commande selon un autre mode de réalisation

### Description détaillée

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

Sur les figures est illustrée une télécommande T configurée pour commander une unité de contrôle U d'une installation de protection solaire I. La télécommande T appartient à l'installation de protection solaire I.

L'installation de protection solaire I peut être de type brise-soleil à lames orientables, stores vénitiens, des pergolas à lames orientables, ou toute forme d'installation ayant au moins un écran solaire apte à être déployé sur une course donnée et/ou orientable sur une plage angulaire donnée. Pour le déplacement des pièces destinées à l'obturation solaire, l'installation de protection solaire I comprend au moins un actionneur A destiné à être commandé par l'unité de contrôle U.

La télécommande T comprend un boitier 10 et un circuit électronique de commande 100 logé dans le boitier 10. Le circuit électronique de commande 100 comprend un émetteur 102 radioélectrique apte à émettre des ondes électromagnétiques adaptées à la commande à distance de l'unité de contrôle U. Plus précisément, les ondes électromagnétiques émises sont représentatives d'un ordre de commande 104 à destination de l'unité de contrôle U, laquelle comprend un récepteur 200 radioélectrique, un microprocesseur et des moyens matériels et logiciels pour convertir l'ordre de commande 104 reçu puis transmettre elle-même un ordre de commande 202 circonstancié à l'actionneur A concerné. L'unité de contrôle U est généralement contenue dans un boitier 204, situé à distance de la télécommande T et préférentiellement incluse dans l'actionneur A.

Le circuit électronique de commande 100 est alimenté par des accumulateurs d'énergie 106 logés dans le boitier 10. Le boitier 10 comprend une partie supérieure 12 et une partie inférieure 14 aptes à êtres assemblées et démontées l'une par rapport à l'autre, soit par un coulissement suivant une direction longitudinale X, soit par encliquetage suivant une direction perpendiculaire à la direction longitudinale X. Le boitier 10 comprend aussi un couvercle amovible 16 donnant accès aux accumulateurs d'énergie 106 en vue de leur remplacement.

La télécommande T comprend aussi une interface homme-machine 300 accessible depuis l'extérieur du boitier 10. L'interface homme-machine 300 comprend une molette de commande 400 apte à être manipulée par la main de l'utilisateur de la télécommande T et montée sur le boitier 10 d'une manière offrant au moins une aptitude de mouvement de rotation de la molette de commande 400 par rapport au boitier 10 autour d'un axe principal Y.

Ainsi, la molette de commande 400 est montée sur le boitier 10 soit selon une liaison pivot à un seul degré de liberté dont l'axe de rotation est l'axe principal Y, soit selon une liaison pivot glissant à deux degrés de liberté dont une rotation autour de l'axe principal Y et une translation le long de l'axe principal Y.

La molette de commande 400 permet par exemple d'ajuster une variable d'état associée à une plage de déplacement ou à une plage d'orientation angulaire de la pièce d'obturation solaire mobile via l'actionneur A.

La molette de commande 100 comprend au moins un élément magnétiquement actif 402 et le circuit électronique de commande 100 comprend un capteur magnétique 108 (par exemple de type à effet Hall ou magnéto-résistif) en situation de couplage magnétique avec l'élément magnétiquement actif 402 d'une manière permettant au circuit électronique de commande 100 d'évaluer le positionnement de l'élément magnétiquement actif 402 par rapport au boitier 10 et d'en déduire un paramètre de commande associé au mouvement de rotation de la molette de commande 400. Le paramètre de commande déduit par le circuit électronique de commande 100 est configuré pour commander, par le biais de l'unité de contrôle U, un paramètre de mouvement associé à l'actionneur A. Dans ce qui précède, le paramètre de commande associé au mouvement de la molette de commande 400 est porté par l'ordre de commande 104 transmis à l'unité de contrôle U par la télécommande T, tandis que le paramètre de mouvement associé à l'actionneur A est porté par l'ordre de commande 202 transmis à l'actionneur A par l'unité de contrôle U. En fonction des besoins et de la précision requise, il peut être prévu un seul élément magnétiquement actif 402, ou bien une pluralité d'éléments magnétiquement actifs 402 répartis autour de l'axe principal Y.

Le paramètre de commande est notamment une position angulaire discrète prise par la molette de commande 400 parmi une pluralité de positions angulaires prédéterminées, mais il pourrait s'agir de la vitesse angulaire de rotation de la molette de commande 400.

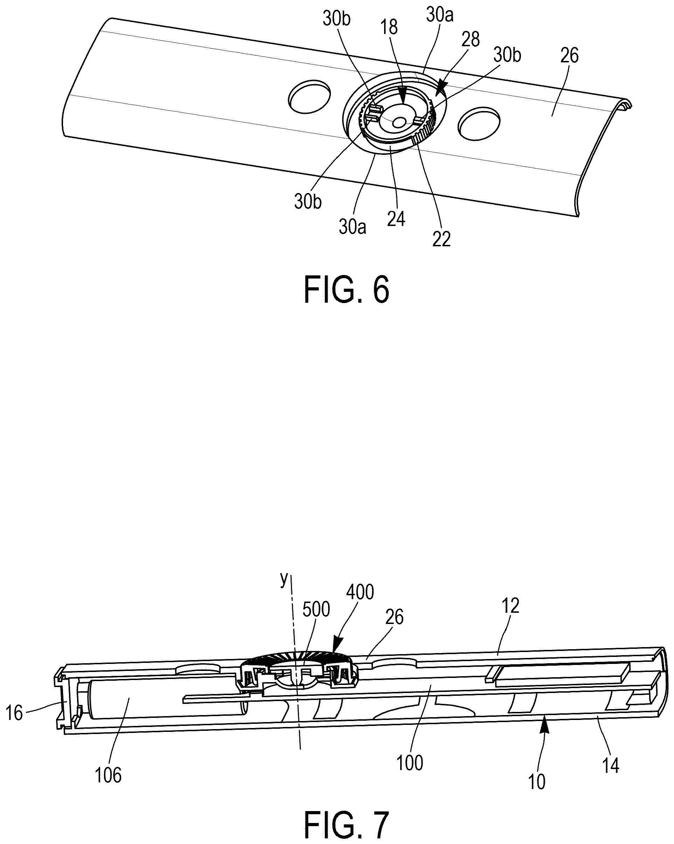

Comme cela est visible sur les figures 6 à 10, le boitier 10 délimite une paroi d'obturation étanche 18 interposée entre le circuit électronique de commande 100 et la molette de commande 400 et configurée pour assurer une continuité de matière avec le reste de la matière du boitier 10 de sorte à conférer une étanchéité aux fluides extérieurs au boitier 10. Comme cela sera expliqué plus loin, la paroi d'obturation étanche 18 est soit constituée en une seule pièce, soit en au moins deux pièces distinctes assemblées l'une avec l'autre de manière conférant l'étanchéité présentée ci-avant.

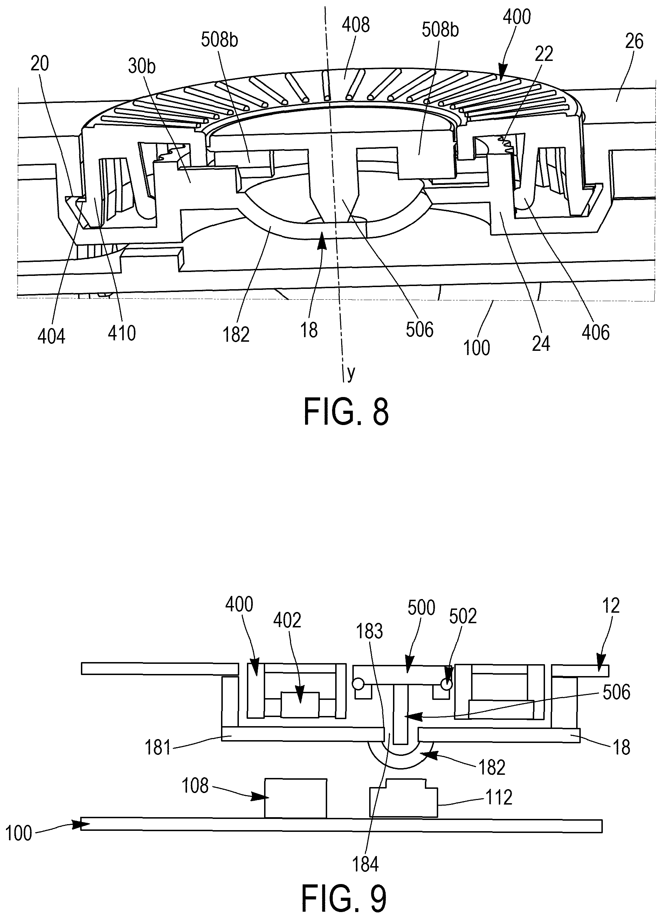

En référence à la figure 8, le boitier 10 et la molette de commande 400 comprennent respectivement des premiers éléments 20 et des deuxièmes éléments 404 d'un même mécanisme de retenue assurant un blocage de la molette de commande 400 par rapport au boitier 10 le long de l'axe principal Y.

Par exemple et comme cela est représenté sur la figure 8, les premiers éléments 20 portés par le boitier 10 sont constitués par un épaulement en creux et les deuxièmes éléments 404 portés par la molette de commande 400 sont constitués par un ou plusieurs rebord(s) périphérique(s) saillant radialement. Il est tout à fait possible d'envisager une configuration inversée. Dans le mode de réalisation illustré, les deuxièmes éléments 404 portés par la molette de commande 400 sont en fait une pluralité de rebords périphériques qui font saillie radialement vers l'extérieur par rapport à l'axe principal Y, chacun de ces rebords périphériques étant délimité par une languette élastiquement déformable 410 ayant une aptitude à un débattement radial de la languette élastiquement déformable 410 de manière radiale par rapport à l'axe principal Y. Ces dispositions permettent d'encliqueter la molette de commande 400 dans le boitier 10 pour bloquer la molette de commande 400 le long de l'axe principal Y.

Le boitier 10 et la molette de commande 400 comprennent respectivement des premiers organes mécaniques 22 et des deuxièmes organes mécaniques 406 d'un même mécanisme d'indexation angulaire et aptes à coopérer entre eux par appui et frottements de sorte à conférer, au sein de la course angulaire de rotation de la molette de commande 400 autour de l'axe principal Y, une pluralité de positions angulaires stables prédéterminées que peut adopter sélectivement la molette de commande 400.

Par exemple et comme cela est représenté sur la figure 8, les premiers organes mécaniques 22 portés par le boitier 10 sont constitués par des crans angulairement répartis autour de l'axe principal Y en étant en saillie radialement vers l'extérieur autour d'une couronne 24 solidaire du boitier 10 et les deuxièmes organes mécaniques 406 portés par la molette de commande 400 sont constitués par des pattes élastiquement déformables radialement par rapport à l'axe principal Y. Il est tout à fait possible d'envisager une configuration inversée.

Comme on peut le voir sur les figures 7 et 8, le boitier 10 présente une face supérieure 26 et un évidement 28 formé en creux dans la face supérieure 26 du boitier 10. La paroi d'obturation étanche 18 matérialise des cloisons à cet évidement 28, notamment des cloisons latérales et une cloison de fond. La molette de commande 400 est positionnée dans l'évidement 28 de sorte qu'une surface de manipulation 408 supérieure de la molette de commande 400 affleure sensiblement avec la face supérieure 26 du boitier 10. Le terme « sensiblement » implique que le décalage entre la face supérieure 26 du boitier 10 et la surface de manipulation 408 de la molette de commande 400 est inférieur ou égal à 2 mm.

Préférentiellement l'au moins un élément magnétiquement actif 402 est constitué par un aimant permanent. La nature du matériau de l'aimant permanent n'est pas limitative en soi.

En référence aux figures, l'interface homme-machine 300 comprend un bouton d'appui 500, indépendant de la molette de commande 400, apte à être manipulé par la main de l'utilisateur de la télécommande T depuis l'extérieur du boitier 10 et monté sur le boitier 10 d'une manière offrant au moins une aptitude de mouvement par rapport au boitier 10 suivant au moins un degré de liberté par pivotement autour d'un axe de basculement orienté transversalement à l'axe principal Y, et/ou par translation le long de l'axe principal Y, pour varier, par application d'un effort manuel sur le bouton d'appui 500 depuis l'extérieur du boitier 10, entre une position de repos et au moins une position d'actionnement.

La molette de commande 400 permet par exemple d'ajuster une variable d'état associée à une plage de déplacement ou à une plage d'orientation angulaire de la pièce d'obturation solaire mobile via l'actionneur A, ou une autre pièce d'obturation solaire mobile par l'intermédiaire d'un autre actionneur distinct de l'actionneur A susmentionné.

Dans la variante représentée non limitative, le bouton d'appui 500 est monté sur le boitier 10 d'une manière offrant uniquement une possibilité de translation le long de l'axe principal Y pour varier, par application de l'effort manuel sur le bouton d'appui, entre une unique position de repos remontée et une unique position d'actionnement enfoncée.

Comme on peut le voir sur les figures, la molette de commande 400 est conformée selon une forme générale tridimensionnelle de couronne, annulaire, et le bouton d'appui 500 est aménagé au centre de cette couronne. Un dispositif d'étanchéité 502 est interposé entre la molette de commande 400 et le bouton d'appui 500, ce dispositif d'étanchéité 502 étant configuré pour participer à une étanchéité aux fluides extérieurs au boitier 10 entre la molette de commande 400 et le bouton d'appui 500 quelle que soit la position angulaire occupée par la molette de commande 400 et quelle que soit la position occupée par le bouton d'appui 500 entre la position de repos et la position d'actionnement. Ce dispositif d'étanchéité peut se présenter sous la forme d'un joint, d'une chicane ou d'une lèvre souple, par exemple.

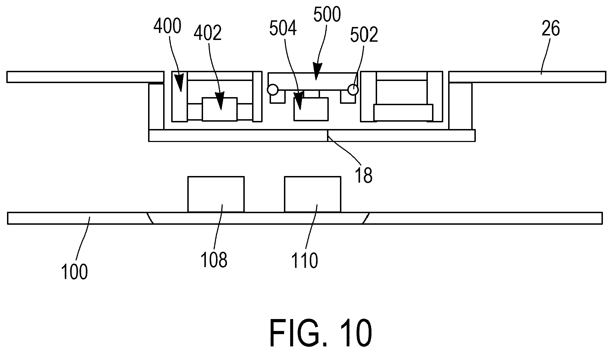

Selon un premier mode de réalisation en référence à la figure 10, le bouton d'appui 500 comprend au moins un corps magnétiquement actif 504 distinct de l'élément magnétiquement actif 402 porté par la molette de commande 400, et le circuit électronique de commande 100 comprend un capteur magnétique 110 (par exemple de type à effet Hall ou magnéto-résistif) en situation de couplage magnétique avec le corps magnétiquement actif 504 d'une manière permettant au circuit électronique de commande 100 d'évaluer le positionnement du corps magnétiquement actif 504 par rapport au boitier 10 et d'en déduire un paramètre associé au mouvement du bouton d'appui 500.

Dans ce qui précède, le paramètre associé au mouvement du bouton d'appui 500 est porté par l'ordre de commande 104 transmis à l'unité de contrôle U par la télécommande T. Le paramètre associé au mouvement du bouton d'appui 500 est notamment une position prise par le bouton d'appui 500 durant sa translation le long de l'axe principal Y.

Dans une première variante telle que représentée, le capteur magnétique 108 qui est en situation de couplage magnétique avec l'élément magnétiquement actif 402 porté par la molette de commande 400 est distinct du capteur magnétique 110 qui en situation de couplage magnétique avec le corps magnétiquement actif 504 porté par le bouton d'appui 504.

Préférentiellement, l'au moins un corps magnétiquement actif est constitué par un aimant permanent. La nature du matériau de l'aimant permanent n'est pas limitative en soi.

En référence maintenant à la figure 9, et selon un second mode de réalisation alternatif et préférentiel afin d'améliorer la précision de détection, le circuit électronique de commande 100 comprend au moins un interrupteur 112 susceptible d'occuper un état actif et un état inactif et le bouton d'appui 500 comprend un organe d'actionnement 506 coopérant mécaniquement avec cet interrupteur 112 à travers la paroi d'obturation étanche 18 et configuré de sorte que l'organe d'actionnement 506 place l'interrupteur 112 dans l'état actif lorsque le bouton d'appui 500 est dans la position d'actionnement et place l'interrupteur 112 dans l'état inactif lorsque le bouton d'appui 500 est dans la position de repos.

Comme on peut le voir sur les figures, la paroi d'obturation étanche 18 comprend d'une part un rebord périphérique 181 présentant un bord interne 183 délimitant une ouverture 184 à contour fermé et d'autre part un bloc central 182 en matière élastomère déformable (par exemple surmoulée) dont un pourtour périphérique est monté de manière étanche sur toute la longueur du bord interne 183 du rebord périphérique 181. Le rebord périphérique 181 vient de matière avec la paroi d'obturation étanche 18 et constitue au moins une partie d'une cloison de fond de la paroi d'obturation étanche 18.

L'interface homme-machine 300 comprend préférentiellement un mécanisme de rappel sollicitant en permanence le bouton d'appui 500 vers sa position de repos. Ainsi, la position de repos du bouton d'appui 500 est une position stable et l'au moins une position d'actionnement du bouton d'appui 500 est une position instable. Préférentiellement et comme cela peut être déduit des figures, le mécanisme de rappel est constitué par le bloc central 182 en matière élastomère déformable.

Comme on le voit sur les figures 8 et 9 essentiellement, le bloc central 182 en matière élastomère déformable présente une forme de dôme faisant saillie en direction du circuit électronique de commande 100 par rapport au rebord périphérique 181.

Le boitier 10 et le bouton d'appui 500 comprennent respectivement des premiers éléments et des deuxièmes éléments d'un même mécanisme de blocage assurant à la fois un blocage bidirectionnel du bouton d'appui 500 par rapport au boitier 10 le long de l'axe principal Y et un blocage en rotation du bouton d'appui 500 autour de l'axe principal Y.

Par exemple et comme cela est représenté sur les figures, la partie 30a des premiers éléments portés par le boitier 10 qui assure le blocage bidirectionnel du bouton d'appui 500 par rapport au boitier 10 le long de l'axe principal Y est constituée par un épaulement en creux et la partie 508a des deuxièmes éléments portés par le bouton d'appui 500 qui assure le blocage bidirectionnel du bouton d'appui 500 par rapport au boitier 10 le long de l'axe principal Y est constituée par un ou plusieurs rebord(s) périphérique(s) saillant radialement. Il est tout à fait possible d'envisager une configuration inversée. La mise en coopération des parties 30a et 508a peut se pratiquer par une rotation du bouton d'appui 500, après enfoncement dans le boitier 10, d'une course angulaire de l'ordre de 90°.

Par exemple et comme cela est représenté sur les figures, la partie 30b des premiers éléments portés par le boitier 10 qui assure le blocage en rotation du bouton d'appui 500 autour de l'axe principal Y est constituée par au moins une cloison solidaire du boitier 10 se dressant en saillie parallèlement à l'axe principal Y et la partie 508b des deuxièmes éléments portés par le bouton d'appui 500 qui assure le blocage en rotation du bouton d'appui 500 autour de l'axe principal Y est constituée par au moins une cloison solidaire du bouton d'appui 500 se dressant en saillie parallèlement à l'axe principal Y, ces cloisons étant destinées à venir en contact les unes contre les autres pour bloquer la rotation du bouton d'appui 500.

## Revendications

1. Télécommande (T) configurée pour commander une unité de contrôle (U) d'une installation de protection solaire (I), la télécommande (T) comprenant :
- un boitier (10),
- un circuit électronique de commande (100) logé dans le boitier (10), le circuit électronique de commande (100) comprenant un émetteur (102) d'ondes électromagnétiques adaptées à la commande à distance de l'unité de contrôle (U),
- une interface homme-machine (300) accessible depuis l'extérieur du boitier (10), l'interface homme-machine (300) comprenant une molette de commande (400) apte à être manipulée par la main de l'utilisateur de la télécommande et montée sur le boitier (10) d'une manière offrant au moins une aptitude de mouvement de rotation de la molette de commande (400) par rapport au boitier (10) autour d'un axe principal (Y),
télécommande (T) dans laquelle :
- la molette de commande (400) comprend au moins un élément magnétiquement actif (402) et le circuit électronique de commande (100) comprend un capteur magnétique (108), le capteur magnétique (108) étant en situation de couplage magnétique avec l'élément magnétiquement actif (402) d'une manière permettant au circuit électronique de commande (100) d'évaluer le positionnement de l'élément magnétiquement actif (402) par rapport au boitier (10) et d'en déduire un paramètre de commande associé au mouvement de rotation de la molette de commande (400), ce paramètre de commande déduit par le circuit électronique de commande (100) étant configuré pour commander, par le biais de l'unité de contrôle (U), un paramètre de mouvement associé à un actionneur (A) de l'installation de protection solaire (I),
- le boitier (10) délimite une paroi d'obturation étanche (18) interposée entre le circuit électronique de commande (100) et la molette de commande (400) et assurant une continuité de matière avec le reste de la matière du boitier (10) de sorte à conférer une étanchéité aux fluides extérieurs au boitier (10).

2. Télécommande (T) selon la revendication 1, dans laquelle le boitier (10) et la molette de commande (400) comprennent respectivement des premiers éléments (20) et des deuxièmes éléments (404) d'un même mécanisme de retenue assurant un blocage de la molette de commande (400) par rapport au boitier (10) le long de l'axe principal (Y).

3. Télécommande selon l'une quelconque des revendications 1 ou 2, dans laquelle le boitier (10) et la molette de commande (400) comprennent respectivement des premiers organes mécaniques (22) et des deuxièmes organes mécaniques (406) d'un même mécanisme d'indexation angulaire et aptes à coopérer entre eux par appui et frottements de sorte à conférer, au sein de la course angulaire de rotation de la molette de commande (400) autour de l'axe principal (Y), une pluralité de positions angulaires stables prédéterminées que peut adopter sélectivement la molette de commande (400).

4. Télécommande (T) selon l'une quelconque des revendications 1 à 3, dans laquelle le boitier (10) présente une face supérieure (26) et un évidement (28) formé en creux dans la face supérieure (26) du boitier (10), la paroi d'obturation étanche (18) matérialisant des cloisons dudit évidement (28) et la molette de commande (400) étant positionnée dans l'évidement (28) de sorte qu'une surface de manipulation (408) supérieure de la molette de commande (400) affleure sensiblement avec la face supérieure (26) du boitier (10).

5. Télécommande (T) selon l'une quelconque des revendications 1 à 4, dans laquelle l'au moins un élément magnétiquement actif (402) est constitué par un aimant permanent.

6. Télécommande (T) selon l'une quelconque des revendications 1 à 5, dans laquelle l'interface homme-machine (300) comprend un bouton d'appui (500), indépendant de la molette de commande (400), apte à être manipulé par la main de l'utilisateur de la télécommande (T) depuis l'extérieur du boitier (10) et monté sur le boitier (10) d'une manière offrant au moins une aptitude de mouvement par rapport au boitier (10) suivant au moins un degré de liberté par pivotement autour d'un axe de basculement orienté transversalement à l'axe principal (Y), et/ou par translation le long de l'axe principal (Y), pour varier, par application d'un effort manuel sur le bouton d'appui (500) depuis l'extérieur du boitier (10), entre une position de repos et au moins une position d'actionnement.

7. Télécommande (T) selon la revendication 6, dans laquelle la molette de commande (400) est conformée selon une forme générale tridimensionnelle de couronne et le bouton d'appui (500) est aménagé au centre de cette couronne.

8. Télécommande (T) selon l'une quelconque des revendications 6 ou 7, dans laquelle le bouton d'appui (500) comprend au moins un corps magnétiquement actif (504) distinct de l'élément magnétiquement actif (402) porté par la molette de commande (400), et le circuit électronique de commande (100) comprend un capteur magnétique (110) en situation de couplage magnétique avec le corps magnétiquement actif (504) d'une manière permettant au circuit électronique de commande (100) d'évaluer le positionnement du corps magnétiquement actif (504) par rapport au boitier (10) et d'en déduire un paramètre associé au mouvement du bouton d'appui (500).

9. Télécommande (T) selon la revendication 8, dans laquelle l'au moins un corps magnétiquement actif (504) est constitué par un aimant permanent.

10. Télécommande (T) selon l'une quelconque des revendications 6 ou 7, dans laquelle :
- le circuit électronique de commande (100) comprend au moins un interrupteur (112) susceptible d'occuper un état actif et un état inactif,
- le bouton d'appui (500) comprend un organe d'actionnement (506) coopérant mécaniquement avec l'interrupteur (112) à travers la paroi d'obturation étanche (18) et configuré de sorte que l'organe d'actionnement (506) place l'interrupteur (112) dans l'état actif lorsque le bouton d'appui (500) est dans la position d'actionnement et place l'interrupteur (112) dans l'état inactif lorsque le bouton d'appui (500) est dans la position de repos.

11. Télécommande (T) selon la revendication 10, dans laquelle la paroi d'obturation étanche (18) comprend d'une part un rebord périphérique (181) venant de matière avec la paroi d'obturation (18) et présentant un bord interne (183) délimitant une ouverture (184) à contour fermé et d'autre part un bloc central (182) en matière élastomère déformable dont un pourtour périphérique est monté de manière étanche sur toute la longueur du bord interne (183) du rebord périphérique (181).

12. Télécommande (T) selon l'une quelconque des revendications 10 ou 11, dans laquelle :
- l'interface homme-machine (300) comprend un mécanisme de rappel sollicitant en permanence le bouton d'appui (500) vers sa position de repos,
- la position de repos du bouton d'appui (500) est une position stable et l'au moins une position d'actionnement du bouton d'appui (500) est une position instable.

13. Télécommande (T) selon les revendications 11 et 12, dans laquelle le mécanisme de rappel est constitué par le bloc central (182) en matière élastomère déformable.

14. Télécommande (T) selon la revendication 13, dans laquelle le bloc central (182) en matière élastomère déformable présente une forme de dôme faisant saillie en direction du circuit électronique de commande (100) par rapport au rebord périphérique (181).

15. Télécommande (T) selon l'une quelconque des revendications 6 à 14, dans laquelle le boitier (10) et le bouton d'appui (500) comprennent respectivement des premiers éléments (30a, 30b) et des deuxièmes éléments (508a, 508b) d'un même mécanisme de blocage assurant un blocage bidirectionnel du bouton d'appui (500) par rapport au boitier (10) le long de l'axe principal (Y) et un blocage en rotation du bouton d'appui (500) autour de l'axe principal (Y).
